# EUROPEAN PATENT SPECIFICATION

(11) **EP 2 201 688 B1**
(45) Date of publication and mention of the grant of the patent: **03.08.2011**
(21) Application number: 08804062.1
(22) Date of filing: 11.09.2008
(51) Int. Cl.: H03M 1/10, H03M 1/46

(54) **METHOD AND DEVICE FOR CONTROLLING A SUCCESSIVE APPROXIMATION REGISTER ANALOGUE TO DIGITAL CONVERTER**
VERFAHREN UND EINRICHTUNG ZUR STEUERUNG EINES ANALOG-DIGITAL-UMSETZERS MIT SUKZESSIVEM APPROXIMATIONSREGISTER
PROCÉDÉ ET DISPOSITIF POUR CONTRÔLER UN CONVERTISSEUR ANALOGIQUE-NUMÉRIQUE DE REGISTRE D'APPROXIMATIONS SUCCESSIVES

(30) Priority: 11.09.2007 DE 102007043145; 27.12.2007 US 16937; 04.09.2008 US 204301
(43) Date of publication of application: 30.06.2010
(73) Proprietor: TEXAS INSTRUMENTS DEUTSCHLAND GMBH, 85356 Freising (DE)
(72) Inventor: GERBER, Johannes, 85716 Unterschleissheim (DE); RUCK, Bernhard Wolfgang, 85354 Freising (DE)
(74) Representative: Holt, Michael
(86) International application number: PCT/EP2008/062097
(87) International publication number: WO 2009/034145

(56) References cited:
- US-B1- 6 538 594
- BRIAN P GINSBURG ET AL: "Dual Time-Interleaved Successive Approximation Register ADCs for an Ultra-Wideband Receiver" IEEE JOURNAL OF SOLID-STATE CIRCUITS, IEEE SERVICE CENTER, PISCATAWAY, NJ, US, vol. 42, no. 2, 1 February 2007 (2007-02-01), pages 247-257, XP011161670 ISSN: 0018-9200

## Description

The present invention relates to successive approximation analogue to digital converters (SAR-ADCs), and more specifically to a method and a device for controlling an SAR ADC.

SAR-ADCs are a specific type of ADC, which typically uses a capacitive array (or array of capacitors) on which an analogue input voltage is sampled. One side of the capacitors in the capacitive array is coupled to an input voltage and the other to a specific reference voltage level, which is typically somewhere in the middle between two other reference voltage levels. Therefore, in the context of this application, this voltage level is referred to as a mid voltage level although it must not necessarily be in the middle of the supply voltage range or in the middle between two reference voltages. After having sampled the input voltage, the respective switches are opened so as to freeze the charge on the capacitors of the capacitive array. All capacitors of the array are coupled with one side to a common node, which is coupled to one input of a comparator. The other input of the comparator receives a comparator reference voltage. After this initial sampling step, the mid voltage is also removed from the input nodes, i.e. from the common node. During conversion, the other side of each capacitor of the capacitive array is switched between two voltage levels (typically two reference voltage levels, where one reference voltage level can also be ground) and the voltage on the common node settles to a specific voltage level, which allows the value of the input voltage to be determined step by step. In each step, a single capacitor of the array is switched from one reference level to another so as to redistribute the charge on the capacitors through the common node. The voltage level on the common node changes accordingly and the comparator detects whether it is greater or smaller than the voltage level at its other input. Thereby, the digital value representing the analog input voltage level is determined step-by-step.

While the input nodes are connected to the mid voltage level, i.e. during the sampling phase of the input voltage, the comparator undergoes an autozeroing step. Any offset introduced by the comparator is determined during this autozeroing step and compensated for during the AD-conversion phase.

However, during the sampling steps, when the mid voltage is not applied any more and the respective switches are opened, additional undesired charge is injected from the switches into the comparator's input nodes. In order to avoid this effect, the input nodes, the switches and the capacitances coupled to the input nodes are designed strictly symmetric. For a symmetric design, the charges from the switches will only cause a common mode voltage, which is suppressed by the common mode rejection ratio (CMRR) of the comparator. However, the CMRR is only limited. Further, any unbalance between the input nodes, the capacitive loads or the switches may result in a differential voltage input voltage to the comparator, which can entail severe degradation of the conversion results.

It is an object of the present invention to provide a method and a device that reduces effects due to charge injection during the adjusting step of a comparator in an SAR-ADC.

In this regard it is noted that United States Patent 6,538,594 discloses a method for controlling a successive approximation register analogue to digital converter the method comprising closing a sampling phase a first switch for connecting a capacitor with one side to an input having an input voltage level, closing a second switch for connecting the capacitor with another side to a mid voltage level, the capacitor being coupled with the same side to a first comparator input opening the first switch and opening the second switch.

Accordingly, the present invention provides a method for controlling a successive approximation register analogue to digital converter. In a sampling phase, a first switch is closed for connecting a capacitor with one side to an input voltage level. A second switch is closed for connecting the capacitor with another side to a mid voltage level. The capacitor is coupled with the same side to a first comparator input. Then the first switch and the second switch are opened and an autozeroing step is performed with the comparator.

The first switch is operable to connect a side of a capacitor (which is for example in a capacitive array) not connected to the comparator input and the mid voltage level to an input voltage. The capacitor is connected to one input of a comparator, for example the positive input. A second switch is operable to additionally connect the same side of the capacitor that is connected to the comparator input to a mid voltage level, for example equal to half the positive supply voltage (VDD/2). During the sampling phase, the first and second switches are closed, so as to connect the capacitor with both the input voltage level and the mid voltage level. After sampling of the input voltage has taken place, the input voltage and mid voltage level are disconnected from the capacitive array by opening the first and second switches. The present invention provides that when the comparator's input nodes are decoupled from the mid voltage level, the comparator still performs the autozeroing step. Consequently, the autozeroing step considers the error charge injected into the capacitive array by the first and second switches and completely cancels the effect of this parasitic charge injection, thus leading to an offset-free transfer function of the analogue to digital converter.

Preferably, the autozeroing step comprises sampling an offset voltage at the first comparator input (the error charge injected into the capacitive array) due to opening of the first and second switches. This has the effect of canceling the offset voltage at the first comparator input. When the first and second switches are opened, they cause a charge injection offset voltage at the input of the comparator. This offset voltage is sampled using sampling circuitry inside the comparator, which can be a capacitor, for example. Also, standard autozeroing circuitry can be used.

Further, a third switch might be provided which is closed during the sampling phase so as to connect the second comparator input (e.g. the negative input) to mid voltage level. Accordingly, both input nodes are connected to mid voltage and the offset of the comparator itself can be determined. If the charges injected by the second and third switches were equal, only common mode voltage would appear at the comparator's input nodes. However, any imbalance of the input nodes and the capacitances of the input nodes leads to differential voltages and therefore to incomplete offset cancellation. The present invention provides that the autozeroing step includes the effects induced by opening the second and also the third switch. Accordingly, the autozeroing step is only carried out or prolonged until all switches, the first, second and third switch are opened.

Ideally the method should comprise prolonging the autozeroing step for a predetermined time after opening the first, second and third switches. The comparator, and the autozeroing circuitry inside the comparator take some time to settle after the switches have been opened. In other words, it takes some time for the autozeroing step to cancel the effect of the parasitic charge injected when the switches are opened. The autozeroing step should then be prolonged or delayed for the time it takes the comparator to settle. In this way, the comparator has time to fully cancel the effect of the parasitic charge injection and associated offset voltage. This can be implemented, for example, by changing the sequence clocking in the SAR state machine.

The present invention also provides an electronic device including control circuitry for controlling a successive approximation register analogue to digital converter. The control circuitry comprises a comparator, a capacitive array having a capacitor with one side configured to be coupled to a first input of the comparator, and switches. The control circuitry is adapted to close a first switch so as to connect another side of the capacitor of the capacitive array to an input voltage level, to close a second switch so as to connect said one side of the capacitor to a mid voltage level. Also, the second input of the comparator can be switched to a mid voltage level by a third switch. The control circuitry according to the present invention is then adapted to perform an autozeroing step of the comparator only when the first and second switches and, if there is a third switch, when the third switch is opened. During the sampling phase of the input voltage onto the capacitive array, the inputs of the comparator are switched to the mid voltage level by closing the second and third switch. Meanwhile, the comparator may already be set in an autozero mode. However, when the mid voltage level is disconnected from the capacitive array by opening the second switch, the comparator still stays in an autozeroing mode. Any induced error charge will then be considered during the autozeroing step of the comparator and will not interfere with the analog to digital conversion. The comparator in its autozero mode should have enough time to settle after the charge injections into the capacitive array due to opening of the first, second and third switches.

The present invention provides also a SAR state machine, which is adapted to perform a sequence of clocking an SAR capacitive digital to analog converter (CDAC, i.e. the capacitive array coupled to the input of the comparator) so as to provide sufficient delay between opening the switches coupling the inputs of a comparator to a mid voltage level and an autozeroing step of the comparator.

The electronic device comprises autozeroing circuitry configured to sample an offset voltage at an input of the comparator. The present invention aims to remove any offset voltage due to opening the switches, but the offset cancellation will include also the internal offset of the comparator. The effect of the offset voltage, caused by the parasitic charge injection upon opening of the switches, is then cancelled at the input of the comparator by the autozeroing circuitry and does not affect the analog to digital conversion. The autozeroing circuitry may be formed of a chain of comparator stages, with each of the stages comprising a comparator having an input for receiving the offset voltage and an output connected to a sampling capacitor for sampling the offset voltage.

Advantageously, the device may further comprise delay circuitry configured to prolong the autozeroing step for a predetermined time after the control circuitry has opened the first, second and/or third switches. After the switches have been opened and inject a parasitic charge into the capacitive array, the comparator takes some time to settle during the autozeroing step before it can fully cancel the effects of the error charge and associated offset voltage. Prolonging the autozeroing step for a time equal to the settling time of the comparator means that the comparator has enough time to settle and that the error charge will be fully offset. The delay circuitry can be implemented, for example, in the sequence clocking in the SAR machine, which can be configured to prolong the autozeroing step to be equal to the settling time of the comparator.

Further advantages and characteristics of the invention ensue from the description below of a preferred embodiment and from the accompanying drawings, in which:
- Figure 1 is a simplified circuit diagram of a part of a circuitry for a successive approximation register analogue to digital converter according to the invention;
- Figure 2 is a simplified circuit diagram of autozeroing circuitry for a successive approximation register analogue to digital converter according to the invention during sampling of a single stage offset during an autozeroing process;
- Figure 3 is a simplified circuit diagram of autozeroing circuitry for a successive approximation register analogue to digital converter according to the invention during an autozeroing process; and
- Figure 4 is a simplified circuit diagram of autozeroing circuitry for a successive approximation register analogue to digital converter according to the invention after an autozeroing process.

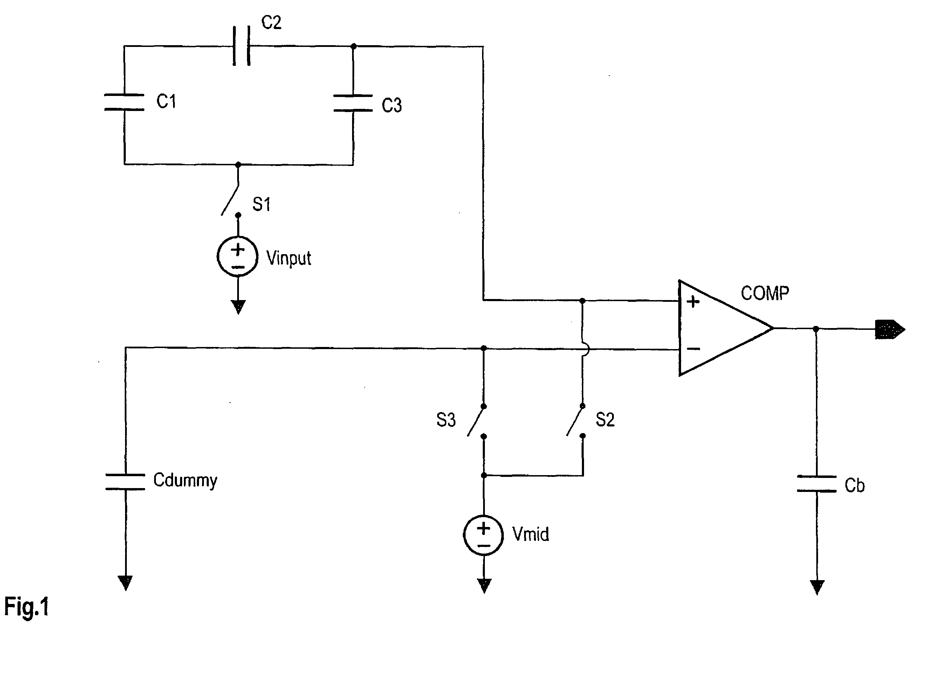

Figure 1 shows a part of a successive approximation register (SAR) analog to digital converter (ADC). A capacitive array is formed from three capacitors C1, C2 and C3, which are connected in a ring formation so that the capacitor C1 is connected with one side to C2 and the other side to C3, C2 is connected with one side to C1 and the other side to C3 and C3 is connected with one side to C1 and with the other side to C2. A node interconnecting the capacitors C1 and C3 is connected via a switch S1 to a voltage input node Vinput. A node interconnecting the capacitors C2 and C3 is connected directly to the positive input of a comparator COMP and is also connected, via a switch S2 to a mid voltage level node Vmid.

The mid voltage level Vmid can be equal to half the positive supply voltage VDD/2, for example. However, the exact value of the mid voltage level Vmid is not decisive and may deviate substantially from the mid voltage of a the voltage supply. The term "mid voltage" is to be understood as a reference to any voltage level, which is appropriate for a specific architecture and implementation of the ADC. A dummy capacitor Cdummy is connected between the negative input of the comparator COMP and ground, with the negative input of the comparator COMP also being connected to the mid voltage level node Vmid via a switch S3. The dummy capacitor Cdummy represents a capacitive load, which can be matched with the capacitive array connected to the other input node of the comparator. Matched values of Cdummy and the capacitive array are useful as charge injections to both input nodes are then converted into similar voltage levels at the input nodes, i.e. there is only a common mode voltage at the comparator input. The common mode voltage level will be suppressed by the comparator's common mode rejection ratio (CMRR). In practice, the capacitive array consisting of C1 to C3 may include many more capacitors and switches. Typically there are sixteen or more capacitors for high resolution SAR ADCs. The clocking and switching scheme for such a capacitive array is well known in the art. The capacitive array is often referred to as a capacitive digital to analog converter (CDAC). A buffering capacitor Cb is provided at the output of the comparator COMP and is connected between the output of the comparator COMP and ground.

During the sampling phase, the switch S1 is closed so that the node interconnecting the capacitors C1 and C3 in the capacitive array is connected to the voltage input node Vinput; i.e., the capacitive array is connected to the input voltage level at the node Vinput. At the same time, the switches S2 and S3 are closed so that both the positive and negative input terminals of the comparator COMP are attached to the mid voltage level Vmid. According to prior art solutions, the comparator COMP stays in an autozeroing mode only when the comparator's input nodes are connected to Vmid. When the sampling phase is finished, the switches S2 and S3 are opened so that the mid voltage level Vmid is disconnected from the capacitive array and from the input terminals of the comparator COMP. The present invention provides that the comparator remains in the autozeroing mode for a certain time after the switches have been opened. As the switches S2 and S3 are opened, there is a parasitic charge injection into the capacitive array comprising the capacitors C1, C2 and C3, and also into the dummy capacitor Cdummy. After this parasitic charge injection into the capacitors C1, C2 and C3 and Cdummy, the input nodes of the comparator COMP are floating, which means that the charge on these input nodes is conserved. Prior art solutions consider the charge injection to be the same on both input pins of the comparator COMP under the assumption of ideal symmetry. The voltage change at both inputs of the comparator COMP will be identical and no error will result. However, in a real circuit there will always be an imbalance, which will result in an offset voltage. According to the present invention, this induced error charge caused by the parasitic charge injection when the switches S2 and S3 are opened is included in the autozero mechanism of the comparator, as described below, and does not appear as an offset during analog to digital (AD) conversion. While the mid voltage level node Vmid is disconnected from the capacitive array comprising the capacitors C1, C2 and C3 by opening the switch S2, the comparator COMP stays in its auto-zero mode, which compensates for the voltage offset at the inputs of the comparator COMP.

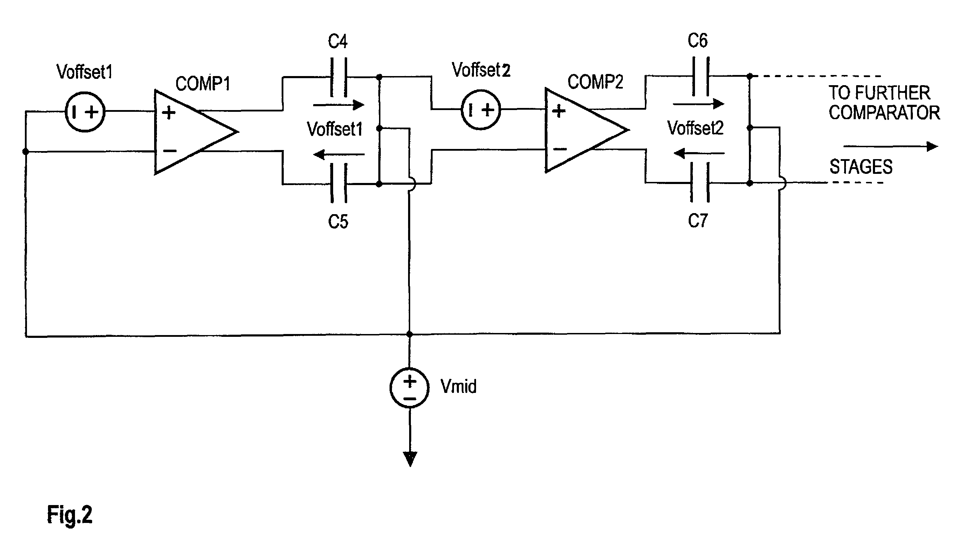

Figures 2 to 4 show autozeroing circuitry in the comparator COMP at different stages in the autozeroing mechanism of the comparator COMP. The autozeroing circuitry comprises several comparator stages connected together in a chain, however, only two are shown here for simplicity. A first comparator COMP1 has its positive input connected to a node Voffset1, which represents the voltage offset at the positive input of the comparator COMP in Figure 1 (and also the voltage offset at the positive input of the first comparator COMP1 in the autozeroing circuitry). The reason for a chain of comparators rather then a single comparator resides in the fact that each comparator acts also as an amplifier. If the amplification or the gain in a comparator is to high, the output voltage saturates and it can be impossible to compensate for the offset. The comparator or rather amplifier stage outputs are connected to capacitors C4 and C5 so that the capacitors C4 and C5 are connected in parallel with each other. The voltage Voffset2 represents the offset voltage at the positive input of the second comparator COMP2. This offset is represented by the second voltage source Voffset2. Therefore, Voffset2 is connected to the positive input of the second comparator COMP2 and the other side of capacitor C4. The other side of the capacitor C5 is connected to the negative input of the second comparator COMP2, with the output stages of the second comparator COMP2 being connected to capacitors C6 and C7. Further comparator stages, represented in Figures 2 to 4 by dotted lines, are connected to the other sides of the capacitors C6 and C7.

Figure 2 shows the sampling of single stage offset in the autozero process during the ADC sampling phase of the SAR AD converter when the input voltage node Vinput is connected to the capacitive array comprising capacitors C1, C2 and C3 in the control circuitry shown in Figure 1. Initially, the inputs (both the positive and the negative inputs) of the comparators COMP1 and COMP2 are shorted to the mid level voltage Vmid and the offset voltage is sampled on the capacitors at each comparator stage output. The offset voltage Voffset1 at the input of the first comparator COMP1 is sampled on the capacitors C4 and C5 and the offset voltage Voffset2 at the input of the second comparator COMP2 is sampled on the capacitors C6 and C7. Thus the offset voltage of each stage is stored at its output capacitors.

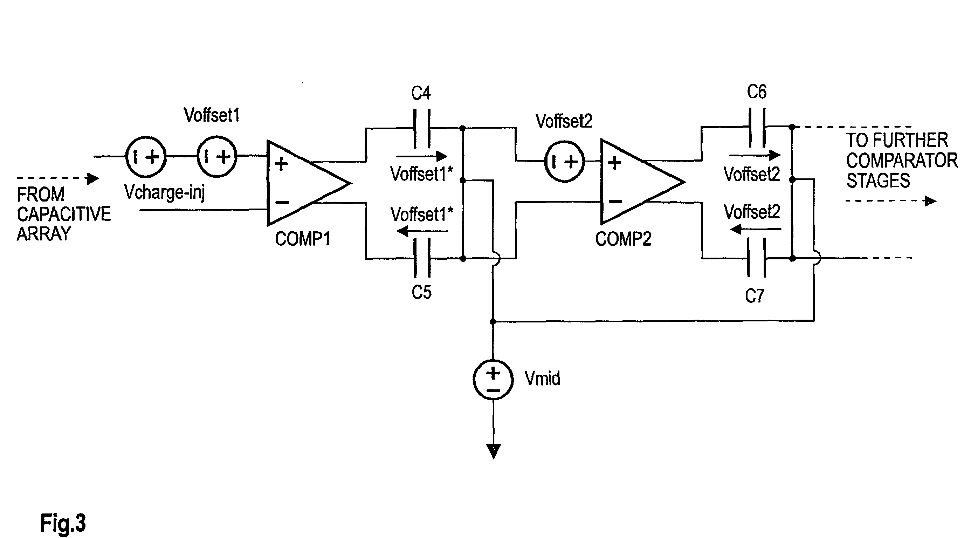

Figure 3 shows the situation when the capacitive array including the capacitors C1, C2 and C3 is disconnected from the mid voltage level node Vmid by opening the switches S2 and S3. As described above, when the switches S2 and S3 are opened there is a parasitic charge injection introduced into the capacitive array. This parasitic charge Vcharge_inj is added on to the voltage offset Voffset at the positive input of the first comparator COMP1 in the autozeroing circuitry. Accordingly, the voltage offset at the positive input of the first comparator COMP1 then increases to Voffset1*, which is sampled on the capacitors C4 and C5 at the output of the first comparator COMP1.

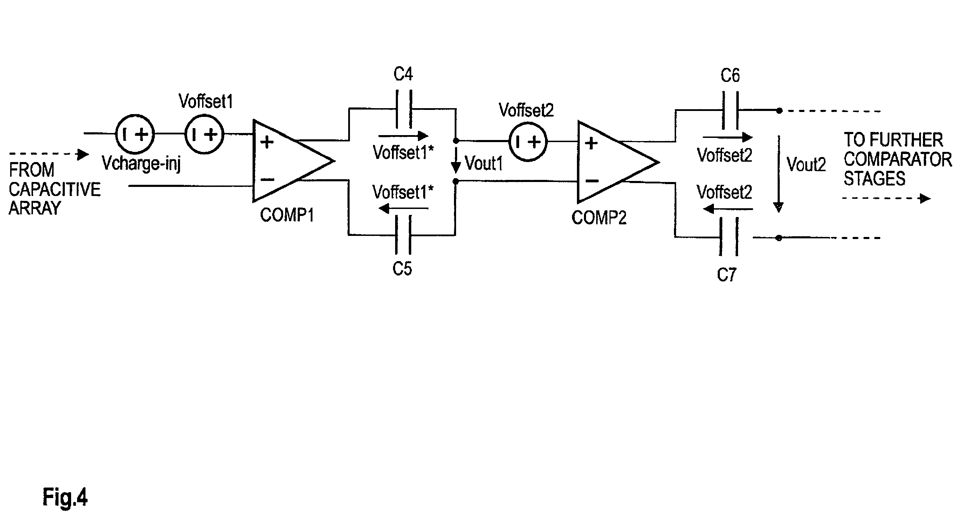

In Figure 4, the autozeroing circuitry is shown in a state in which the autozeroing process is terminated after the capacitive array comprising the capacitors C1, C2 and C3 has been disconnected from the mid level voltage node Vmid by opening the switches S2 and S3. Once the autozeroing process is terminated, the voltage offset at the input of each comparator stage is stored on the capacitors at the output of each comparator stage. In the example shown here, the total voltage offset Voffset1* at the first comparator COMP1 is stored on the capacitors C4 and C5 and the voltage offset Voffset2 at the second comparator COMP2 is stored on the capacitors C6 and C7. Because the voltage offset at each comparator stage is stored at the output of each stage, the voltage offset at the input of the comparator stages is cancelled. Accordingly, the output voltages Vout1 and Vout2 are practically zero. The offset compensation of the first comparator stage will also contain the effect of the offset voltage Vcharge_inj caused by opening the switches S2 and S3, thus the error charge induced at the input of the comparator COMP will not appear as an offset during analog to digital conversion.

The comparator COMP in auto-zero mode should be given enough time to settle after the switches S2 and S3 are opened (i.e., the capacitive array is disconnected from the mid voltage level Vmid) and the charge injection has taken place before the autozeroing process is terminated. Delay circuitry should then be provided, which prolongs the autozeroing process by a predetermined time; i.e., the time it takes for the comparator to settle and for the voltage offsets to be sampled on the capacitors in the autozeroing circuitry. This can be achieved by adding an additional delay time, for example by changing the sequence clocking in the SAR state machine. Thereby, the autozeroing step is extended into the hold phase, which follows the sampling phase.

Although the present invention has been described with reference to a particular embodiment, it is not limited to this embodiment and no doubt further alternatives will occur to the skilled person that lie within the scope of the invention as claimed.

## Claims

1. A method for controlling a successive approximation register analogue to digital converter, the method comprising closing in a sampling phase a first switch (S1) for connecting a capacitor (C3) with one side to an input having an input voltage level (Vinput), closing a second switch (S2) for connecting the capacitor with another side to a mid voltage level(Vmid), the capacitor being coupled with the same side to a first comparator (COMP) input, opening the first switch, opening the second switch, **characterized by** performing an autozeroing step with the comparator.

2. The method according to claim 1, further comprising prolonging the autozeroing step for a predetermined time after opening the first and second switches.

3. The method according to claim 1 or claim 2, comprising further closing in the sampling phase a third switch for connecting a second comparator input to a mid voltage level and performing the autozeroing step only after opening the third switch.

4. An electronic device including control circuitry for controlling a successive approximation register analogue to digital converter, the control circuitry comprising a comparator (COMP), a capacitive array (C1,C2,C3) having a capacitor (C3) with one side configured to be coupled to a first input of the comparator, and switches (S1,S2,S3), the control circuitry being adapted to close a first switch (S1) so as to connect another side of the capacitor of the capacitive array to a input voltage level (Vinput), to close a second switch (S2) so as to connect said one side of the capacitor to a mid voltage level (Vmid), to open the first switch, to open the second switch, and **characterized in that** the control circuitry is further adapted to perform an autozeroing step with the comparator.

5. The electronic device according to claim 4, wherein the electronic device comprises autozeroing circuitry configured to sample an offset voltage due to opening the first and second switches at the first input of comparator.

6. The electronic device according to claim 5, wherein the autozeroing circuitry is formed of a chain of comparator stages (COMP1, COMP2), each of said stages comprising a comparator having an input for receiving the offset voltage and an output connected to a sampling capacitor (C5,C7) for sampling the offset voltage.

7. The electronic device according to any one of claims 4 to 6, further comprising delay circuitry configured to prolong the autozeroing step for a predetermined time after the control circuitry has opened the first and second switches.

## Patentansprüche

1. Verfahren zur Steuerung eines Analog-Digital-Wandlers mit sukzessiver Approximation, wobei das Verfahren das Schließen eines ersten Schalters (S1) in einer Abtastphase, um eine Seite eines Kondensators (C3) mit einem Eingang, der einen Eingangsspannungspegel (Vinput) aufweist, zu verbinden, das Schließen eines zweiten Schalters (S2), um eine andere Seite des Kondensators mit einem mittleren Spannungspegel (Vmid) zu verbinden, wobei der Kondensator mit derselben Seite mit einem ersten Eingang eines Komparators (COMP) gekoppelt ist, das Öffnen des erstes Schalters, das Öffnen des zweiten Schalters umfasst, **gekennzeichnet durch** das Durchführen eines Schritts der automatischen Offsetkompensation mit dem Komparator.

2. Verfahren gemäß Anspruch 1, ferner umfassend das Verlängern des Schritts der automatischen Offsetkompensation um eine vorbestimmte Zeit nach Öffnen des ersten und des zweiten Schalters.

3. Verfahren gemäß Anspruch 1 oder Anspruch 2, ferner umfassend das Schließen eines dritten Schalters in der Abtastphase, um einen zweiten Komparatoreingang mit einem mittleren Spannungspegel zu verbinden, und das Durchführen des Schritts der automatischen Offsetkompensation erst nach Öffnen des dritten Schalters.

4. Elektronische Vorrichtung, einschließlich einer Steuerschaltung zur Steuerung eines Analog-Digital-Wandlers mit sukzessiver Approximation, wobei die Steuerschaltung einen Komparator (COMP), eine kapazitive Anordnung (C1, C2, C3) mit einem Kondensator (C3), dessen eine Seite so konfiguriert ist, dass sie mit einem ersten Eingang des Komparators gekoppelt wird, und Schalter (S1, S2, S3) umfasst, wobei die Steuerschaltung so eingerichtet ist, dass sie einen ersten Schalter (S1) schließt, um eine andere Seite des Kondensators der kapazitiven Anordnung mit einem Eingangsspannungspegel (Vinput) zu verbinden, einen zweiten Schalter (S2) schließt, um die eine Seite des Kondensators mit einem mittleren Spannungspegel (Vmid) zu verbinden, den ersten Schalter öffnet, den zweiten Schalter öffnet, und **dadurch gekennzeichnet, dass** die Steuerschaltung ferner so eingerichtet ist, dass sie einen Schritt der automatischen Offsetkompensation mit dem Komparator durchführt.

5. Elektronische Vorrichtung gemäß Anspruch 4, bei der die elektronische Vorrichtung eine Schaltung zur automatischen Offsetkompensation umfasst, die so konfiguriert ist, dass sie an dem ersten Eingang des Komparators eine durch Öffnen des ersten und des zweiten Schalters verursachte Offsetspannung abtastet.

6. Elektronische Vorrichtung gemäß Anspruch 5, bei der die Schaltung zur automatischen Offsetkompensation aus einer Kette von Komparatorstufen (COMP1, COMP2) gebildet ist, wobei jede der Stufen einen Komparator umfasst, der einen Eingang zum Empfangen der Offsetspannung und einen Ausgang hat, der mit einem Abtastkondensator (C5, C7) zur Abtastung der Offsetspannung verbunden ist.

7. Elektronische Vorrichtung gemäß einem der Ansprüche 4 bis 6, ferner umfassend eine Verzögerungsschaltung, die so konfiguriert ist, dass sie den Schritt der automatischen Offsetkompensation um eine vorbestimmte Zeit verlängert, nachdem die Steuerschaltung den ersten und den zweiten Schalter geöffnet hat.

## Revendications

1. Procédé destiné à commander un convertisseur analogique - numérique à registre d'approximations successives, le procédé comprenant les étapes consistant à: fermer dans une phase d'échantillonnage un premier commutateur (S1) de façon à connecter un condensateur (C3) dont un premier côté est relié à une entrée qui présente un niveau de tension d'entrée (Vinput); fermer un deuxième commutateur (S2) de façon à connecter le condensateur dont l'autre côté est relié à un niveau de tension intermédiaire (Vmid), le même côté du condensateur étant couplé à une entrée d'un premier comparateur (COMP); ouvrir le premier commutateur; ouvrir le deuxième commutateur, **caractérisé par** l'exécution d'une étape de remise à zéro automatique avec le comparateur.

2. Procédé selon la revendication 1, comprenant en outre une étape consistant à prolonger l'étape de remise à zéro automatique pendant un temps prédéterminé après l'ouverture des premier et deuxième commutateurs.

3. Procédé selon la revendication 1 ou la revendication 2, comprenant en outre les étapes consistant à: fermer, dans la phase d'échantillonnage, un troisième commutateur de façon à connecter une seconde entrée du comparateur à un niveau de tension intermédiaire; et exécuter l'étape de remise à zéro automatique seulement après l'ouverture du troisième commutateur.

4. Dispositif électronique comprenant des circuits de commande destinés à commander un convertisseur analogique - numérique à registre d'approximations successives, les circuits de commande comprenant un comparateur (COMP), un réseau capacitif (C1, C2, C3) qui présente un condensateur (C3) dont un premier côté est configuré de façon à être couplé à une première entrée du comparateur, et des commutateurs (S1, S2, S3), les circuits de commande étant adaptés de façon à: fermer un premier commutateur (S1) afin de connecter l'autre côté du condensateur du réseau capacitif à un niveau de tension d'entrée (Vinput); fermer un deuxième commutateur (S2) afin de connecter ledit premier côté du condensateur à un niveau de tension intermédiaire (Vmid); ouvrir le premier commutateur; ouvrir le deuxième commutateur ; et **caractérisé en ce que** les circuits de commande sont adaptés en outre de façon à exécuter une étape de remise à zéro automatique avec le comparateur.

5. Dispositif électronique selon la revendication 4, dans lequel le dispositif électronique comprend des circuits de remise à zéro automatique configurés de façon à échantillonner une tension de décalage due à l'ouverture des premier et deuxième commutateurs au niveau de la première entrée du comparateur.

6. Dispositif électronique selon la revendication 5, dans lequel les circuits de remise à zéro automatique sont constitués par une chaîne d'étages de comparateur (COMP1, COMP2), chacune desdits étages comprenant un comparateur qui présente une entrée destinée à recevoir la tension de décalage et une sortie connectée à un condensateur d'échantillonnage (C5, C7) de façon à échantillonner la tension de décalage.

7. Dispositif électronique selon l'une quelconque des revendications 4 à 6, comprenant en outre des circuits de retard configurés de façon à prolonger l'étape de remise à zéro automatique pendant un temps prédéterminé une fois que les circuits de commande ont ouvert les premier et deuxième commutateurs.
